Europäisches Patentamt

(19) European Patent Office

Office européen des brevets

(11) Publication number: **0 142 938**
**B1**

(12) **EUROPEAN PATENT SPECIFICATION**

(45) Date of publication of patent specification: **13.01.88**

(21) Application number: **84307060.8**

(22) Date of filing: **16.10.84**

⑩⑩ Consolidated with **84903901.1/0161273**
(European application No./publication No.) by
decision dated **15.04.87.**

(51) Int. Cl.⁴: **H 01 L 23/48,** H 01 L 23/50

(54) Semiconductor integrated circuit including a lead frame chip support.

(30) Priority: **21.10.83 US 544420**

(43) Date of publication of application:
**29.05.85 Bulletin 85/22**

(45) Publication of the grant of the patent:
**13.01.88 Bulletin 88/02**

(84) Designated Contracting States:
**DE FR GB IT NL**

(56) References cited:
**WO-A-84/01470**
**GB-A-2 112 204**

(73) Proprietor: **AMERICAN TELEPHONE AND**
**TELEGRAPH COMPANY**
**550 Madison Avenue**
**New York, NY 10022 (US)**

(72) Inventor: **Graver, Ronald Norman**
**2033 Latta Street**
**Allentown Pennsylvania 18104 (US)**

(74) Representative: **Watts, Christopher Malcolm**
**Kelway, Dr. et al**
**Western Electric Company Limited 5,**
**Mornington Road**
**Woodford Green Essex, IG8 0TU (GB)**

Courier Press, Leamington Spa, England.

## Description

### Background of the Invention

This invention relates to integrated circuits of the type comprising a semiconductor chip disposed on a lead frame within a multi-terminal package. The invention is particularly concerned with the problem of distributing power to different portions of the chip.

As known, one type of integrated circuit comprises a plurality of semiconductor devices arranged in various circuit configurations on a single semiconductor chip. The chip is mounted on a central or "paddle" portion of a lead frame, connecting wires extend between bonding sites on the chip and different ones of the frame leads, and the chip-lead frame assembly is encapsulated within a solid, plastic-like enclosure, the leads from the lead frame extending outwardly from the enclosure and providing terminals or "pins" for the device package.

It is often necessary, depending upon the chip circuit configuration, to provide electrical power to different portions of the semiconductor chip. One approach is to provide a power distribution network on the chip itself, only two interconnecting wires thus being required between the chip and the package terminals. However, the power distribution network tends to be large and the chip size must be increased to accommodate it. This is generally undesirable.

Another approach is to provide power at several different package terminals and to interconnect each of the different terminals to different portions of the chip where the power is required. However, this increases the number of terminals required which is also generally undesirable.

### Statement of the Invention

In accordance with this invention, power is distributed to different portions of the chip using a specially designed lead frame. The chip support paddle of the lead frame is split electrically and provides two conductor members that extend along and under the chip. The two conductor members are connected to different package terminals, between which electrical power is applied, and the two conductor members serve as power busses, disposed not on the chip itself, from which power can be derived by means of different connecting wires between bonding sites on the chip and the conductor members.

### Description of the Drawing

FIG. 1 is a perspective view of a portion of a lead frame designed in accordance with one aspect of the invention;

FIG. 2 is a perspective view, partly cut away, of the lead frame encapsulated in a dual-in-line package;

FIG 3 is a view similar to FIG. 2 showing a chip installed.

### Detailed Description

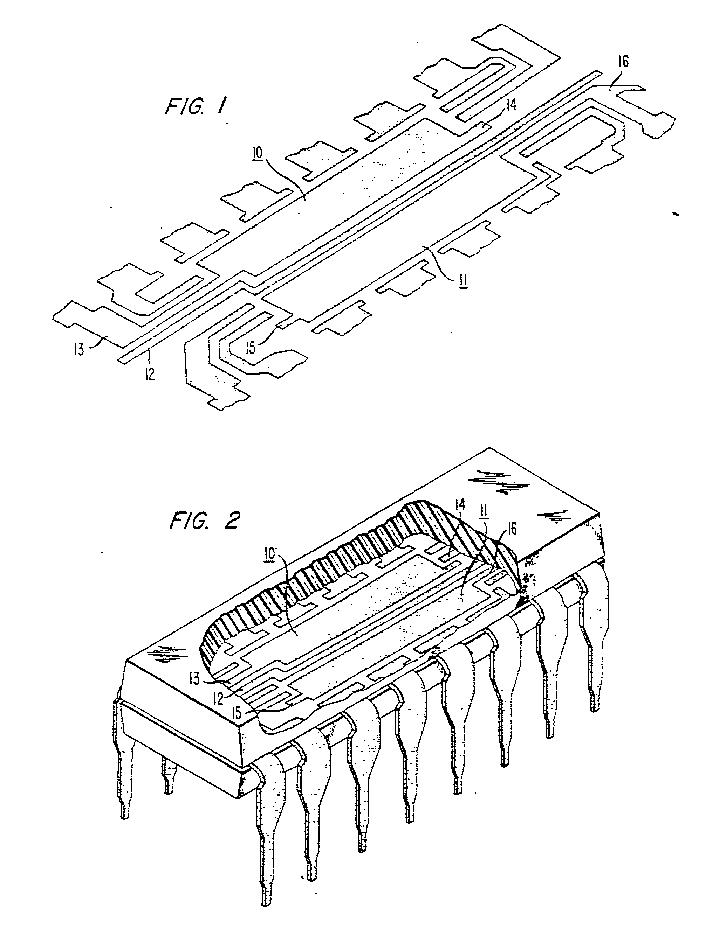

A lead frame designed with power and ground plane buss bars is shown in FIG. 1. The lead frame is of generally standard type, comprising a thin metal foil or film having etched openings therethrough providing the pattern of elements shown. Not shown (as being well known) is a peripheral continuous element to which all the various frame elements are connected thus providing a unitary, self-supporting member. In use, as known, a semiconductor chip is mounted on a central or "paddle" portion of the frame, connecting wires are bonded between bonding sites along the edge of the chip and bonding sites on different ones of the frame elements or leads surrounding the paddle, and the semiconductor chip along with adjacent portions of the surrounding leads is encapsulated in a solid, plastic-like envelope. The frame peripheral connecting element is then removed, separating the various leads which serve as terminals of the package.

In accordance with this invention, the usual chip paddle is split into two sections 10 and 11 designed to extend or cross under the chip when the chip is bonded to the paddle. Wire bonding sites 13, 14 for crossunder 10; 15, 16 for crossunder 11 are provided as shown. The arrangement illustrated in FIG. 1 is merely one of numerous crossunder configurations that can be used. Bonding sites can be provided at the edges as well as, or instead of, the ends of the package.

FIG. 2 shows the lead frame, encapsulated within a standard dual-in-line package. For clarity the assembly is shown without the chip. Each of the paddle sections 10 and 11 is integral with a different one of the package terminals by means of which power can be applied to the two sections.

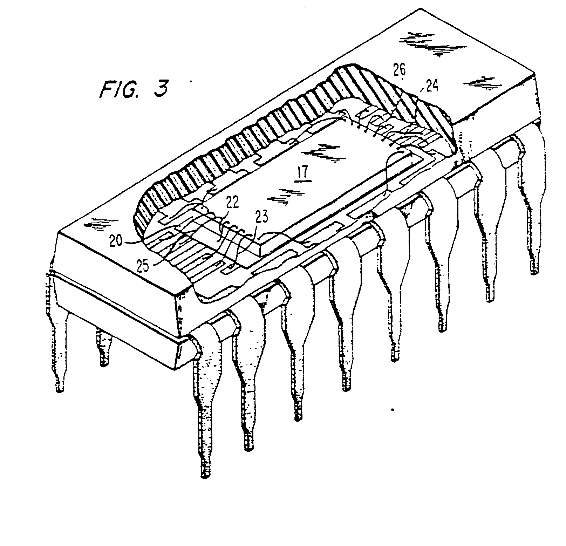

FIG. 3 shows the assembly with the chip 17 bonded in place. Interposed between the chip and the paddle is a plastic sheet 20 with a conductive layer on the upper side. The plastic sheet provides electrical isolation for the sections of the paddle while the metal clad side is the conventional back plane contact for the chip. The wire bonds are shown in FIG. 3. Wire 22 is the connection for the back plane. Wires 23 and 24 are the power connections from the power pads on opposite sides of the chip to paddle 11. Wires 25 and 26 are ground connections to paddle 10. Additional portions of the chip can be connected to the power buss sections 10 and 11 as desired, e.g., from side portions of the chip to exposed portions of the sections 10 and 11 (not in the embodiment illustrated) along the elongated sides of the chip.

To minimize noise in the integrated circuit chip it is often helpful to connect a capacitor between the power and ground busses. With "on-chip" busses, such capacitor consumes additional chip area. With the arrangement of this invention the capacitor can be connected conveniently across the power and ground busses externally of the chip.

## Claims

1. An integrated circuit device comprising:
a metal lead frame having a central support member and a plurality of leads extending outward from the vicinity of the central support member, a semiconductor chip (17) bonded to the central support member, conductive members (20—26) connecting sites on the semiconductor chip to sites on the leads, and an envelope encapsulating the semiconductor chip, the central support member, the conductive members, and a portion of the leads,
characterized in that the central support member is segmented into two electrically separate portions (10, 11) extending beyond edges of the chip, conductive members (24, 25) connecting different sites on the chip to different ones of sites on the support portions, and insulating means (20) electrically insulating the underside of the chip from the support portions.

2. The device of claim 1 further including a conductive layer interposed between the chip and the insulating means, and a conductive member (22) interconnecting said conductive layer and said chip.

3. The device of claim 1 having a capacitor interconnecting the two support portions.

## Patentansprüche

1. Integrierte Halbleiterschaltung mit folgenden Merkmalen:
ein metallischer Leiterrahmen weist ein zentrales Trägerglied und eine Mehrzahl von Leitungen auf, die sich nach außen von der Nähe des zentralen Trägergliedes erstrecken; ein Halbleiterchip (17) wird an das zentrale Trägerglied gebondet, Leiterglieder (20—26) verbinden Stellen an dem Halbleiterchip mit Stellen an den Leitungen, und eine Umhüllung kapselt den Halbleiterchip, das zentrale Trägerglied, die leitenden Glieder und einen Teil der Leitungen ein,
dadurch gekennzeichnet, daß das zentrale Trägerglied in zwei elektrisch getrennte Teile (10, 11) gegliedert ist, die sich über Ränder des Chips hinaus erstrecken, daß leitende Glieder (24, 25) unterschiedliche Stellen des Chips mit entsprechenden unterschiedlichen Stellen der Trägerteile verbinden und
daß eine Isoliereinrichtung (20) die Unterseite des Chips gegenüber den Trägerteilen elektrisch isoliert.

2. Halbleiterschaltung nach Anspruch 1, dadurch gekennzeichnet, daß eine leitende Schicht zwischen dem Chip und der Isolationseinrichtung gefügt ist und daß ein leitendes Glied (22) diese leitende Schicht mit dem Chip verbindet.

3. Halbleiterschaltung nach Anspruch 1, dadurch gekennzeichnet, daß ein Kondensator die beiden Trägerteile miteinander verbindet.

## Revendications

1. Un dispositif à circuit intégré comprenant:
un cadre de montage en métal comportant un élément de support central et un ensemble de conducteurs qui s'étendent vers l'extérieur à partir du voisinage de l'élément de support central, une puce de semiconducteur (17) soudée sur l'élément de support central, des éléments conducteurs (20—26) connectant des emplacements sur la puce de semiconducteur à des emplacements sur les conducteurs, et une enveloppe qui encapsule la puce de semiconducteur, l'élément de support central, les éléments conducteurs et une partie des conducteurs,
caractérisé en ce que l'élément de support central est divisé en deux parties électriquement séparées (10, 11) qui s'étendent au-delà de bords de la puce, des éléments conducteurs (24, 25) connectent différents emplacements sur la puce à différents emplacements sur les parties de support, et des moyens d'isolation (20) isolent électriquement la face inférieure de la puce par rapport aux parties de support.

2. Le dispositif de la revendication 1, comprenant en outre une couche conductrice intercalée entre la puce et les moyens d'isolation, et un élément conducteur (22) qui interconnecte cette couche conductrice et la puce.

3. Le dispositif de la revendication 1, comportant un condensateur qui interconnecte les deux parties de support.

FIG. 1

FIG. 2

FIG. 3